# EUROPÄISCHE PATENTSCHRIFT

(11) **EP 2 397 022 B1**
(45) Veröffentlichungstag und Bekanntmachung des Hinweises auf die Patenterteilung: **29.11.2017**
(21) Anmeldenummer: 10711598.2
(22) Anmeldetag: 11.02.2010
(51) Int. Cl.: H05K 9/00

(54) **KABELANSCHLUSSVORRICHTUNG, DAMIT VERSEHENE LEITUNGSDURCHFÜHRUNG SOWIE VERWENDUNG DER SELBEN**
CABLE CONNECTION DEVICE, LINE FEEDTHROUGH PROVIDED THEREWITH, AND USE THEREOF
DISPOSITIF DE RACCORDEMENT DE CÂBLE, TRAVERSÉE ÉQUIPÉE D'UN TEL DISPOSITIF ET UTILISATION DUDIT DISPOSITIF

(30) Priorität: 12.02.2009 DE 102009008506
(43) Veröffentlichungstag der Anmeldung: 21.12.2011
(73) Patentinhaber: Airbus Operations GmbH, 21129 Hamburg (DE)
(72) Erfinder: DEIMEL, Peter, 85465 Langenpreising (DE); BROWNJOHN, Nicholas E., 81614 Buxtehude (DE)
(74) Vertreter: Kastel, Stefan
(86) Internationale Anmeldenummer: PCT/EP2010/051684
(87) Internationale Veröffentlichungsnummer: WO 2010/092101

(56) Entgegenhaltungen:
- WO-A2-98/41077
- DE-C1- 3 711 937
- DE-C1- 19 838 951
- US-A1- 2004 118 582

## Beschreibung

Die Erfindung betrifft eine Kabelanschlussvorrichtung zum Anschließen eines Kabels an ein elektrisch abzuschirmendes Gehäuse nach dem Oberbegriff des Patentanspruchs 1, wie sie z.B. in der DE 198 38 951 C1 offenbart ist. Auf diese Druckschrift wird hiernach noch näher eingegegangen. Außerdem betrifft die Erfindung eine mit einer solchen Kabelanschlussvorrichtung versehene Leitungsdurchführung zum Durchführen einer optischen oder elektrischen Leitung durch eine Durchführungsöffnung in einem elektromagnetisch abzuschirmenden Gehäuse, wie insbesondere Metallgehäuse. Schließlich betrifft die Erfindung eine Verwendung einer solchen Kabelanschlussvorrichtung.

Es ist oft erwünscht oder notwendig, elektronische Bauteile gegenüber elektromagnetischer Strahlung abzuschirmen. Zum Beispiel sollen für die Funktion eines Luftfahrzeuges wichtige elektronische Bauteile nicht durch elektromagnetische Strahlung von außen beeinflusst werden. Auch ist es vielfach erwünscht, elektromagnetische Strahlung absendende elektronische Bauteile derart abzuschirmen, dass sie benachbarte Komponenten nicht beeinflussen. Hierzu werden elektronische Bauteile vielfach in Metallgehäusen untergebracht. Wenn allerdings elektrische oder optische Leitungen an die elektronischen Bauteile angeschlossen werden sollen, sind Durchführungsöffnungen notwendig, durch die elektromagnetische Strahlung eindringen könnte.

Zum Anschluss werden oft abgeschirmte Kupferkabel verwendet, wobei die Abschirmung durch eine elektrisch leitfähige Außenhülle gebildet wird. Wird diese Abschirmung mit dem Metallgehäuse verbunden, dann bildet die Abschirmung des Kabels nur eine Verlängerung der Abschirmung des Metallgehäuses. Wenn die Abschirmung des Kabels nicht mit dem Metallgehäuse verbunden wird, unterliegt es elektrischem Fluss und es gibt keinen Abschirmeffekt. Wenn das Kupferkabel nicht abgeschirmt ist, wirkt das Kabel gerade wie eine Antenne, die elektromagnetische Strahlung in das Metallgehäuse hinein oder aus dem Metallgehäuse heraus führt. Insofern wird bei elektrischen Leitungen, wie insbesondere Kupferkabeln, eine elektromagnetische Abschirmung durch elektrische Verbindung einer metallischen Umhüllungsschicht des Kabels mit dem Metallgehäuse bereits vielfach verwendet. Dagegen werden Durchführungen von optischen Leitungen oft vernachlässigt. Optische Leitungen werden meist aus Glasfaserkabeln und aus sonstigen elektrisch nicht leitfähigen Materialien gebildet. Das die Faseroptiken durch elektromagnetische Strahlung nicht beeinflusst werden und auch selbst nicht strahlen, gibt es die Tendenz zu der Annahme, dass keine elektromagnetische Abschirmung erforderlich sei. Tatsächlich brauchen die optischen Fasern in ihrem Außenverlauf nicht abgeschirmt zu werden. Jedoch stellt die Schnittstelle zwischen den optischen Leitungen und einer abzuschirmenden Elektronik ein Problem dar. Insbesondere stellt der optische Verbinder ein Problem dar. Wenn ein optisches Kabel durch die äußere Abschirmung eines Metallgehäuses hindurchgeführt wird, stellt dies ein Fenster dar, durch welche elektromagnetische Strahlung in das Abschirmungsgehäuse hinein oder aus dem selben heraus gelangen kann.

Aus der EP 0 497 463 A2, der WO 2004/097 484 A1 sowie der US 2006/0239620 A1 sind Kabelanschlussvorrichtungen zum Anschließen optischer Leitungen bekannt, die als Verbinder von optischen Faserkabeln ausgebildet sind und eine gewisse elektromagnetische Abschirmung bewirken.

In der DE 20 2005 020 718 U1 ist ein Kabeldurchführungselement aus einem elastischen Grundmaterial mit elektrisch leitfähigem Grundmaterial offenbart, das eine Dichtlippe zum Umschließen und Fixieren eines durchzuführenden Kabels aufweist.

Die DE 10 2005 016 340 B3 beschreibt eine Vorrichtung zur universellen Kabeldurchführung mit einer Dichtlippe aus einem elastischen Grundmaterial, die eine Mehrzahl von stufenförmigen Lamellen zum Umschließen und Fixieren eines durchzuführenden Kabels aufweist.

In der DE 196 01 518 A1 ist ein Gehäuse für eine elektrische Baugruppe offenbart, das ein Fixiermittel zur Fixierung von elektrischen Anschlusskabeln aufweist.

Aus der eingangs erwähnten DE 198 38 951 C1 ist eine Kabelanschlussvorrichtung nach dem Oberbegriff des Patentanspruches 1 in Form einer hochfrequenzdichten Durchführung bekannt, die eine an einem elektrisch leitenden Gehäuse angeordnete Rinne und ein elastisch-nachgiebiges Anpresselement aufweist. In der Rinne wird das durch das Anpresselement mit seiner metallblanken Schirmung an dem Boden der Rinne kontaktierend angepresste Kabel um 90° umgelenkt.

Die DE 699 08 312 T2 offenbart eine Durchführung mit einem abdichtenden Bund, wobei der Bund Erhebungen zur gasdichten Abdichtung der Durchführung aufweist.

In der US 2004/011858211 ist eine Struktur zum Unterdrücken von Rauschen für ein abgeschirmtes Kabel offenbart, an deren Ausgang versetzt zueinander gegenüberliegende leitfähige Dichtungen angebracht sind.

Gegenüber diesem Stand der Technik ist es Aufgabe der Erfindung, eine Kabelanschlussvorrichtung derart auszubilden, dass sie bei einfacherem Aufbau universeller einsetzbar ist und möglichst eine verbesserte elektromagnetische Abschirmung zur Verfügung stellt.

Diese Aufgabe wird durch eine Kabelanschlussvorrichtung mit den Merkmalen des beigefügten Anspruches 1 gelöst.

Vorteilhafte Ausgestaltungen der Erfindung sind Gegenstand der Unteransprüche.

Vorteilhafte Verwendungen der Erfindung sind Gegenstand der Nebenansprüche.

Die Erfindung schafft eine Kabelanschlussvorrichtung zum Anschließen eines Kabels an ein elektromagnetisch abzuschirmendes Gehäuse mit einer Umhüllung, die zum Umgeben des Kabels im Bereich einer Kabeldurchführungsöffnung des Gehäuses dient und zumindest an ihrer Oberfläche elektrisch leitfähig ausgebildet ist, wobei die Umhüllung eine dem Gehäuse zugeordneten Kabeldurchführungsöffnung in einer Richtung axial zur Kabeldurchführungsöffnung gesehen vollständig überdeckt.

Erfindungsgemäß ist weiter vorgesehen, dass die Umhüllung auf einer zu dem aufzunehmenden Kabel gerichteten inneren Oberfläche mit Abschirmstrukturen zur Dämpfung elektromagnetischer Strahlung versehen ist.

Die erfindungsgemäße Kabelanschlussvorrichtung hat eine Umhüllung, welche derart ausgebildet ist, dass sie ein Kabel im Bereich einer Kabeldurchführungsöffnung des Gehäuses umgibt und die vollständig oder zumindest an einer ihrer Oberflächen elektrisch leitfähig ausgebildet ist. Die Umhüllung ist weiter derart ausgebildet, dass sie einer Kabeldurchführungsöffnung, durch welche das Kabel oder eine Leitung hindurchzuführen ist, in der Axialrichtung der Kabeldurchführungsöffnung gesehen vollständig überdeckt. Dadurch können keine elektromagnetischen Strahlungen auf geradlinig durchgängigem Weg durch die Kabeldurchführungsöffnung gelangen. Zusätzlich weist die Umhüllung auf einer inneren Oberfläche, die zu dem aufzunehmenden Kabel hin gerichtet ist, Abschirmstrukturen zur Dämpfung elektromagnetischer Strahlung auf. Dadurch lassen sich elektromagnetische Wellen, welche entlang der inneren Oberfläche der Umhüllung in das Gehäuse eindringen wollen, dämpfen, so dass weder über eine direkte Einstrahlung noch über die Innenoberfläche der Umhüllung elektromagnetische Strahlung in das abzuschirmende Gehäuse hinein oder aus dem selben heraus geleitet werden kann.

Durch diesen verblüffend einfachen Aufbau lässt sich eine universelle Kabelanschlussvorrichtung schaffen, mit der sowohl optische Kabel als auch elektrische Kabel an ein elektromagnetisch abzuschirmendes Gehäuse im Bereich einer Kabeldurchführungsöffnung des Gehäuses elektrisch abgeschirmt anschließbar sind.

In besonders bevorzugter Weise lässt sich die Umhüllung als Kabelzugentlastung ausführen. Insofern ist neben der Abschirmfunktion auch gleichzeitig eine Funktion als Zugentlastung realisierbar.

Die Überdeckung der Kabeldurchführungsöffnung wird vorzugsweise derart erreicht, dass die Umhüllung das Kabel auf einer abgewinkelten oder gekrümmten Bahn führt. Zwischen einem der Kabeldurchführungsöffnung des Gehäuses zugeordneten Endbereich der Umhüllung und einem Kabeleingang, wo das Kabel von außen in die Umhüllung eintritt, wird das Kabel somit auf einer gekrümmten oder abgewinkelten Bahn geführt. Es gibt somit keine geradlinige Durchführung durch die Umhüllung, so dass elektromagnetische Strahlung, die in die Umhüllung eintreten sollte, zumindest einfach umgelenkt werden müsste, um durch die Umhüllung hindurch zu gelangen. Solche Strahlung wird aber durch die Abschirmstrukturen abgeschwächt, so dass eine perfekte Abschirmung möglich ist.

Beispielsweise ist die Umhüllung zum Umlenken des Kabels um etwa 45 bis 135 Grad, vorzugsweise um ca. 60 bis 120° und mehr insbesondere um etwa 90° ± 5°, ausgebildet. Insbesondere wird das Kabel um etwa 90 Grad oder entsprechend benachbarte Winkel, beispielsweise zwischen 60 - 120 Grad liegend umgelenkt. Besonders bevorzugt ist eine rechtwinklige Ablenkung.

Insbesondere zum Dämpfen von mechanischen Belastungen an dem Kabel - zum Beispiel Stöße oder plötzliche Zugbelastungen - ist weiter bevorzugt, dass die Umhüllung aus elastischem Material, beispielsweise aus Gummimaterial oder aus Polymer gebildet ist. Um die Abschirmfunktion zu erfüllen, ist dieses Material entweder selbst vollständig elektrisch leitfähig ausgebildet - also beispielsweise als elektrisch leitfähiges Gummimaterial oder leitfähiges Polymer ausgebildet - oder zumindest an seiner inneren Oberfläche - vorzugsweise vollständig - mit einem elektrisch leitfähigen Material beschichtet oder überzogen.

Gemäß einem Aspekt der Erfindung weisen die elektromagnetischen Abschirmstrukturen optische Baffles und / oder elektromagnetische Baffles auf.

Gemäß einem weiteren Aspekt weisen die Abschirmstrukturen mehrere Rippen auf. Die Rippen sind quer zum Kabelverlauf angeordnet. Dabei stehen die Rippen zu dem Ort, an dem das Kabel aufzunehmen ist, hervor.

Die Baffles oder Rippen können in regelmäßigen Abständen aufeinander folgen, ähnlich wie dies bei optischen Baffles in optischen Geräten bereits bekannt ist. Es sind aber auch unregelmäßige Abstände möglich und eventuell auch vorteilhaft. Durch unregelmäßige Abstände können z.B. eventuelle Resonanzen vermieden werden. Beispielsweise sind die Abstände der Baffles oder Rippen im Bereich eines Eingangs der Kabelanschlussvorrichtung größer und im Bereich einer Krümmung oder Abwinklung kleiner ausgebildet.

Die Kabelanschlussvorrichtung kann zum Anschließen eines optischen Kabels oder eines elektrischen Kabels verwendet werden. Besonders bevorzugt wird sie als Zugentlastung für optische Kabel eingesetzt, welche gleichzeitig eine Abschirmung der Kabeldurchführungsöffnung liefert.

Gemäß eines weiteren Aspekts ist eine Leitungsdurchführung zum Durchführen einer optischen oder elektrischen Leitung durch eine Durchführungsöffnung in einem elektromagnetisch abzuschirmenden Gehäuse geschaffen, wobei die Leitungsdurchführung ein optisches oder elektrisches Kabel aufweist, welches durch die als Kabeldurchführungsöffnung ausgebildete Durchführungsöffnung hindurch geführt ist und weiter mit der erfindungsgemäßen Kabelanschlussvorrichtung zum Abschirmen der Kabeldurchführungsöffnung versehen ist.

Die Kabelanschlussvorrichtung ist vorzugsweise an die Dicke des Kabels angepasst. Vorzugsweise kontaktieren die Abschirmstrukturen die Außenwand des Kabels. Dadurch werden die optischen Abschirmstrukturen so nah wie möglich an das Kabel herangeführt, so dass auf der Oberfläche des Kabels laufende elektromagnetische Wellen durch die Abschirmstrukturen gedämpft werden. Im Falle eines abgeschirmten Kupferkabels könnte so auch ein Kontakt der äußeren Abschirmung des Kupferkabels mit dem Metallgehäuse hergestellt werden. Weiter wird so eine eventuelle Funktion als Kabelzugentlastung besonders vorteilhaft gewährleistet.

Ausführungsbeispiel der Erfindung werden nachfolgend anhand der beigefügten Zeichnungen näher erläutert. Darin zeigt:
- Figur 1: eine schematische Schnittdarstellung durch eine erste Ausführungsform einer Kabelanschlussvorrichtung;
- Figur 2: eine schematische Schnittansicht durch eine zweite Ausführungsform einer Kabelanschlussvorrichtung;
- Figur 3: eine schematische Schnittansicht durch eine dritte Ausführungsform einer Kabelanschlussvorrichtung; und
- Figur 4: einen Schnitt entlang der Linie IV-IV von Figur 3; und
- Figur 5: ein Eingansbereich einer abgewandten Ausführungsform der Kabelanschlussvorrichtung.

In den Figuren sind unterschiedliche Ausführungsformen einer insgesamt mit 10 bezeichneten Kabelanschlussvorrichtung dargestellt, wobei für gleiche oder entsprechende Teile die gleichen Bezugsziffern verwendet sind. Die Kabelanschlussvorrichtung 10 wird zum Bilden einer Leitungsdurchführung 12 eingesetzt, bei der ein optisches oder elektrisches Kabel 14 durch eine Kabeldurchführungsöffnung 18 in einem Metallgehäuse 20 geleitet wird.

Das Metallgehäuse 20 dient zur Aufnahme einer (nicht dargestellten) Elektronik, die gegen elektromagnetische Strahlung von außen oder gegen Absendung von elektromagnetischer Strahlung von der Elektronik abzuschirmen ist. Daher ist diese Elektronik in dem elektrisch leitfähigen Metallgehäuse 20 untergebracht. Jedoch könnte elektromagnetische Strahlung durch die Kabeldurchführungsöffnung 18 hindurch gelangen.

Kabel 14, die aus einem elektromagnetisch dichten Metallgehäuse 20 führen, können dazu führen, dass elektromagnetische Strahlung in das Metallgehäuse 20 eindringen kann. Dies kann umso mehr geschehen, wenn es sich bei dem Kabel 14 um optische Faserkabel handelt, die aus dem Metallgehäuse 20 optische Daten transportieren.

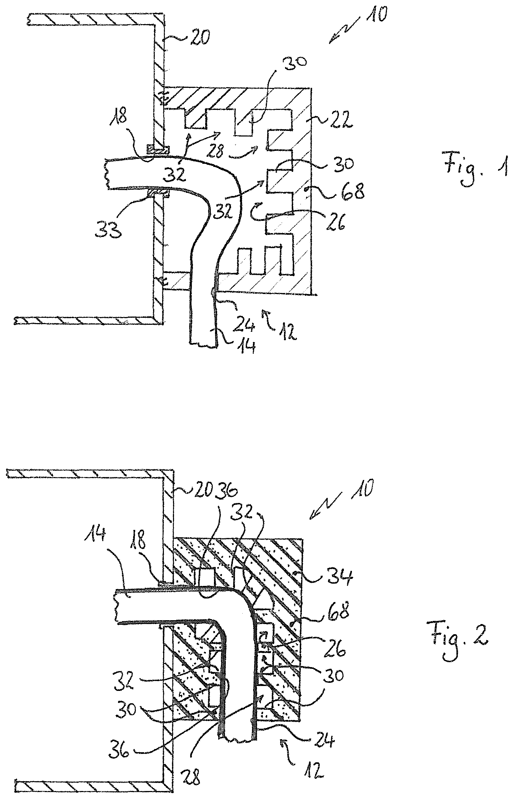

In Figur 1 ist daher eine erste Ausführungsform einer Kabelanschlussvorrichtung 10 dargestellt, um die Kabeldurchführungsöffnung 18 gegen Eindringen von elektromagnetischer Strahlung oder gegen Aussendung von elektromagnetischer Strahlung abzuschirmen. Die Kabelanschlussvorrichtung 10 gemäß Figur 1 weist ein kleineres Gehäuse ("Dog-housing") aus elektrisch leitfähigem Material, insbesondere aus Metall auf. Dieses Gehäuse 22 hat eine weitere Öffnung 24 - Eingangsöffnung -, die im Winkel von im wesentlichen 90 Grad zur Kabeldurchführungsöffnung 18 liegt. Somit wird verhindert, dass elektromagnetische Strahlung in das abzuschirmende Metallgehäuse 20 eindringt. Auf der dem Kabel 14 zuzuwendenden inneren Oberfläche 26 des Gehäuses 22 sind weiter elektromagnetische Abschirmstrukturen 28 vorgesehen. Die Abschirmstrukturen 28 weisen sogenannte optische Baffles 30 auf, welche derart ausgebildet sind, dass elektromagnetische Wellen, die an der inneren Oberfläche 26 verlaufen, gedämpft werden.

Hierzu sind mehrere Rippen 32, die integral aus dem elektrisch leitfähigen Material des Gehäuses 22 gebildet sind, vorgesehen.

Bei dem in Figur 2 dargestellten zweiten Ausführungsbeispiel der Kabelanschlussvorrichtung 10 ist anstelle des Gehäuses 22 aus Metall ein quaderförmiger Block 34 aus leitfähigem Gummimaterial eingesetzt. Zum Bilden der Kabelanschlussvorrichtung 10 sowie der Leitungsdurchführung 12 ist dieser Block 34 in zwei Stücke geschnitten, wobei in dessen Inneren eine Kabelführungsnut 36 zum Führen des Kabels 14 in einem im wesentlichen 90 Grad betragenden Winkel eingebracht ist. Bei dem in Figur 2 dargestellten Beispiel ist diese Kabelführungsnut 36 wiederum mit den Baffles 30 beziehungsweise mit den Rippen 32 versehen. Nach Aufnahme des Kabels 14 werden die beiden Hälften wieder miteinander und mit dem Metallgehäuse 20 verklebt.

An dem Block 34 ist im Bereich der Kabeldurchführungsöffnung 18 ein ringförmiger Vorsprung zum Eingreifen in diese Durchführungsöffnung 18 des Metallgehäuses 20 gebildet. Dadurch lässt sich einerseits ein guter metallischer Leitungskontakt mit dem Metallgehäuse 20 herstellen, andererseits wird das Kabel 14 gegenüber Scheuern an der Kabeldurchführungsöffnung 18 geschützt. Der Schutz gegen Scheuern wird bei der Ausführungsform gemäß Figur 1 durch einen Gummiring 33 bereitgestellt. Bei der Ausführungsform gemäß Figur 2 ist dieser Gummiring 33 integral mit dem Block 34 ausgebildet.

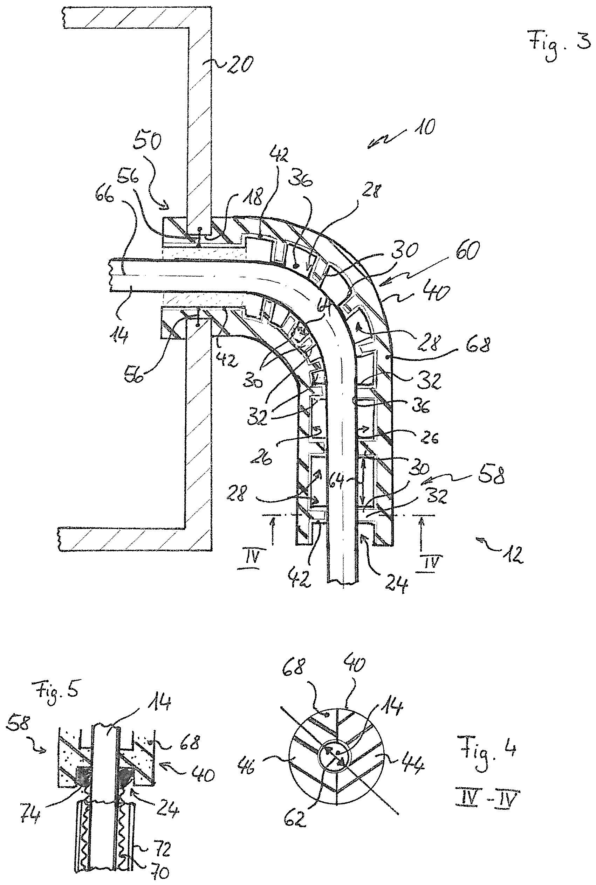

In den Figuren 3 und 4 ist eine besonders bevorzugte weitere Ausführungsform der Kabelanschlussvorrichtung 10 dargestellt, wobei die Kabelanschlussvorrichtung gleichzeitig als Kabelzugentlastung 40 ausgebildet ist. Diese Ausführungsform gemäß den Figuren 3 und 4 wird im Folgenden näher erläutert.

Die Kabelzugentlastung 40 ist im Inneren, an ihrer dem Kabel 14 zuzuwendenden inneren Oberfläche 26 mit optischen Baffles 30 in Form von Rippen 32 versehen und um etwa 90 Grad gebogen, so dass keine elektromagnetische Strahlung durch die Kabeldurchführungsöffnung 18 in das Metallgehäuse 20 eindringen beziehungsweise aus dem Inneren des Metallgehäuses 20 entweichen kann.

Die Anordnung von sogenannten Baffles 30 innerhalb der Kabelzugentlastung 40 und eine Krümmung 60 um etwa 90 Grad der Kabelzugentlastung 40 verhindert ein Eindringen beziehungsweise eine Emission von elektromagnetischer Strahlung in oder aus metallischen Gehäusen wie beispielsweise aus dem Metallgehäuse 20.

Im Prinzip kann die Kabelzugentlastung 40 auch gerade sein, bei einer (nicht dargestellten) Ausführungsform der Kabelzugentlastung mit geradem Verlauf ist die Kabelzugentlastung 40 aber versetzt zu der Kabeldurchführungsöffnung 18 angeordnet, so dass keine gerade Sichtlinie von außen durch die Kabeldurchführungsöffnung 18 besteht. Allgemein ist die Kabelanschlussvorrichtung 10 derart ausgebildet, dass sie in Richtung axial zur Kabeldurchführungsöffnung 18 gesehen, die Kabeldurchführungsöffnung 18 möglichst vollständig überdeckt, so dass eben keine gerade Sichtlinie in das Metallgehäuse 20 hinein besteht und elektromagnetische Strahlung nicht auf geradlinigem Wege durch die Kabeldurchführungsöffnung 18 hindurch gelangen kann.

Durch die dargestellte Kabelzugentlastung 40 wird neben der Funktion einer Zugentlastung auch eine elektromagnetische Abschirmung bereitgestellt. Vorteilhaft gibt es somit keine Emission beziehungsweise Immission von elektromagnetischer Strahlung durch Öffnungen in dem Metallgehäuse 20.

Die Baffles 30 sind derart angeordnet, dass sie Mikrowellen davon abhalten, in elektronische Kästen einzudringen.

Die Kabelzugentlastung 40 für das beispielsweise als optisches Kabel ausgebildete Kabel 14, welches aus dem Metallgehäuse 20 heraustritt, ist aus elektrisch gleitfähigem Gummimaterial oder einen leitfähigem Polymer gebildet. Zur Herstellung können beide Materialien in einer speziellen Form oder Abgussform gegossen - beispielsweise spritzgegossen - werden. Bei der Verwendung bei elektrisch leitfähigem Gummimaterial oder elektrisch leitfähigem Polymer ist die gesamte Kabelzugentlastung 40 elektrisch leitfähig ausgebildet.

Für eine Dämpfung elektromagnetischer Strahlungen reicht es im Prinzip aber auch aus, wenn eine Oberflächenschicht 42 an der inneren Oberfläche 26 elektrisch leitfähig ausgebildet ist.

Beispielsweise wird die Kabelzugentlastung 40, wie dies in Figur 4 dargestellt ist, aus zwei Hälften 44 und 46 gebildet, die zwischen sich das Kabel 14 aufnehmen.

Elektrisch leitfähige Gummimaterialien oder Polymermaterialien zum Bilden dieser Hälften 44, 46 sind beispielsweise auf dem Markt von der Firma Seal Sience Incoperated, 17 131 Daimler Street, Ervine, CA 92614 -5508, erhältlich. Andererseits könnte auch ein nicht leitfähiger Gummi oder ein nicht leitfähiges Polymermaterial vorgesehen sein, das auf der inneren Oberfläche 26 mit der leitfähigen Oberflächenschicht 42 versehen ist. Die Oberflächenschicht 42 könnte beispielsweise durch ein als elektromagnetisch abschirmendes Material wirkendes Material - z.B. Schrumpfmaterial - gebildet werden, wie es beispielsweise von der Firma Chomerics, Parker Hannifin Corporation erhältlich ist.

Die Kabelzugentlastung 40 könnte vergleichbar wie der Block 34 an das Metallgehäuse 20 angeklebt werden. Bei der in Figur 3 dargestellten Ausführungsform ist ein der Kabeldurchführungsöffnung 18 zugeordneter erster Endbereich 50 außenseitig mit einer Ringnut 52 zur Aufnahme des Randes 54 der Kabeldurchführungsöffnung 18 vorgesehen. Zum Anschließen wird demnach der erste Endbereich 50 durch die Kabeldurchführungsöffnung 18 gedrängt, bis die Ringnut 52 den Rand 54 formschlüssig aufnimmt. Diese Verbindung ist ähnlich der Verbindung der außenseitig genuteten Gummischeibe - Gummiring 33 -, welche bei der Ausführungsform gemäß Figur 1 dazu dient, eine Isolierung eines durch die Kabeldurchführungsöffnung 18 hindurchgeführten Kabels 14 vor einer Beschädigung durch den Rand 54 zu schützen. Bei der Ausführungsform gemäß Figur 1 ist dieser Gummiring 33 in engen Kontakt mit der Außenwandung und einer eventuellen Abschirmung des Kabels 14.

Wie dies in Figur 3 durch gestrichelte Linien dargestellt ist, könnte bei einer entsprechenden weiteren Ausführungsform der Kabelzugentlastung 40 auch der innere Bereich des ersten Endbereiches 50 entsprechend eng ausgestaltet sein, so dass er die Außenwandung des Kabels 14 mit engen Kontakt umschließt.

In dem ersten Endbereich 50 ist für eine Ausführungsform aus nicht-leitfähigem Material mit leitfähiger Oberflächenschicht 42 noch eine elektrisch leitfähige Verbindung 56 dieser Oberflächenschicht 42 mit dem Metallgehäuse 20 angedeutet.

In Figur 3 ist nur eine einzelne Leitungsdurchführung 12 für ein einzelnes Kabel 14 dargestellt. In der Regel wird es mehrere solche Leitungsdurchführungen 12 für eine Vielzahl von Kabeln 14 geben. Vorzugsweise ist für jedes dieser Kabel 14 eine eigene Kabelzugentlastung 40 vorgesehen. Dadurch können die Baffles 30 in engen Kontakt mit dem Kabel 14 liegen. Auch kann eine Krümmung um etwa 90° zwischen der Kabeldurchführung 18 und der Eingangsöffnung 24 gebildet werden, so dass sichergestellt wird, dass die elektromagnetische Strahlungen die Baffles 30 trifft und dort absorbiert wird. Es ist zwar grundsätzlich denkbar und möglich, dass durch eine Kabelzugentlastung 40 mehrere Kabel 14 geführt werden, jedoch ist das Hauptziel der hier gezeigten Konstruktion, dass die Kabelführungsnut 36 und die zwischen dem ersten Endbereich 50 und dem die Eingangsöffnung 54 aufweisenden zweiten Endbereich 58 liegende Krümmung 60 genügend Baffles 30 oder Rippen 32 beinhalten kann, um elektromagnetische Strahlung sicher zu dämpfen und zu vermeiden, dass diese elektromagnetische Strahlung in das Metallgehäuse 20 eintritt oder aus dem Metallgehäuse 20 hinaustritt.

Sind mehrere Kabel 14 mit unterschiedlichen Durchmessern vorgesehen, dann werden auch entsprechend ausgebildete Kabelzugentlastungen 40 mit an den jeweiligen Durchmesser angepasster Kabelführungsnut 36 vorgesehen. Die Konstruktion ist jeweils derart, dass ein Lochdurchmesser 62, der Biegeradius der Krümmung 60 und die Folge von Baffles 30 oder Rippen 32 elektromagnetische Strahlung an einem Eintreten in das Gehäuse 20 oder einem Heraustreten daraus hindern.

Der Abstand 64 zwischen den einzelnen Baffles 30 oder Rippen 32 muss nicht unbedingt äquidistant sein. Wie in Figur 3 dargestellt, kann der Abstand 64 derart sein, dass der Abstand 64 zwischen den Rippen am zweiten Endbereich 58 nahe der Eingangsöffnung 24 groß ist, jedoch im Bereich der Krümmung 60 kleiner wird.

Wie bereits oben erwähnt, ist bei dem in Figur 3 und 4 dargestellten Ausführungsbeispiel die Kabelzugentlastung 40 aus wenigstens zwei Teilen - erste und zweite Hälfte 44, 46 - gebildet. In einer nicht dargestellten weiteren Ausführungsform ist die Kabelzugentlastung 40 in einem Stück - beispielsweise durch Spritzguss - ausgeformt. Die Ausführungsform mit zwei Hälften 44, 46 wird zur besseren Führung des Kabels 14 bevorzugt. Die beiden Hälften 44, 46 sind derart aneinander geklebt, dass das Kabel 14 auch in Kabellängsrichtung - in Figur 3 durch eine strichpunktierte Linie 66 dargestellt - festgehalten wird.

In der dargestellten Ausführungsform sind die Baffles 30 oder Rippen 32 aus dem gleichen Material wie die das Kabel 14 umgebende Umhüllung 68 ausgebildet. Zumindest die durch die Oberflächenschicht 42 gebildete innere Oberfläche 46 mit den Baffles 30 und Rippen 32 ist elektrisch leitfähig ausgebildet. Somit sind die Abschirmstrukturen 28 elektrisch leitfähig. Wie bereits erwähnt, kann dies im Prinzip durch zwei Maßnahmen erreicht werden. Die Baffles 30 oder Rippen 32 könnten - wie die gesamte Umhüllung 68 und Kabelzugentlastung 40 aus elektrisch leitfähigem Material gebildet sein. In einer anderen Ausführung ist nur die Oberflächenschicht 42 elektrisch leitfähig ausgebildet. Wie dies herstellungstechnisch realisiert wird, ist bereits oben beschrieben worden.

In einer weiteren - hier nicht näher dargestellten - Ausführungsform ist lediglich eine röhrenartige Umhüllung 68 mit ebener innerer Oberfläche vorgesehen, in welche eine Innenhülse aus elektrisch leitfähigem Material eingeführt ist, an welcher die Abschirmstrukturen 28 aus dem Material der Innenhülse ausgebildet sind.

Figur 5 stellt als schematische Schnittansicht nur des zweiten Endbereichs 58 im Bereich der Eingangsöffnung 54 die Situation dar, wenn das Kabel 14 ein mit - z.B. gewobener - elektrischer Abschirmschicht 70 unterhalb einer äußeren Isolierungsschicht 72 versehenes Kabel ist. In diesem Fall wird die Abschirmschicht 70 durch eine elektrische Verbindung 74 mit der Kabelzugentlastung 40 und damit mit dem Metallgehäuse 20 elektrisch leitfähig verbunden. Die Abschirmschicht 70 endet gerade innerhalb des Eingangsbereiches zu dem mit den Abschirmstrukturen 28 versehenen Abschnitt, um sicherzustellen dass jegliches Restsignal hin zu den Baffles 30/ Rippen 32 hin strahlt und dort absorbiert oder reflektiert wird und gerade nicht innerhalb einer umflechteten Röhre weitergeleitet wird.

Ein Vorteil der in Figur 3 dargestellten als Kabelzugentlastung 40 ausgeführten Kabelanschlussvorrichtung 10 gegenüber den in Figuren 1 und 2 dargestellten blockartigen Kabelanschlussvorrichtungen ist, dass das Kabel 14 und die Kabelzugentlastung 40 im Prinzip auch in andere Richtungen gebogen werden kann oder auch um das Zentrum der Kabeldurchführungsöffnung 18 als Drehpunkt gedreht werden kann. Solange die Krümmung 60 derart erhalten bleibt, dass es keine direkte Sichtlinie zwischen der Kabeldurchführungsöffnung 18 und der Eingangsöffnung 24 gibt, bleibt die Abschirmwirkung zumindest weitgehend erhalten.

Die Baffles 30 oder Rippen werden als Stopper oder absorbierende Punkte in einem elektrisch leitfähigen Material verwendet. Dort hat eine elektromagnetische Strahlung ein totes Ende und wird absorbiert, bevor sie das Metallgehäuse 20 erreicht oder aus dem Metallgehäuse 20 kommend aus der Eingangsöffnung 24 heraustritt. Vergleichbare optische Baffles werden bereits bei optischen Instrumenten zur Abschirmung optischer Streustrahlung verwendet, wie dies beispielsweise von Lucimara C.N. Scaduto et al. in dem Artikel "Baffle Design and Analysis of Stray-light in Multispectral Camera of a Brazilian Satellite - Annals of Optiks, 2006 näher beschreiben wird. Dort wird allerdings nur Streulicht entsprechend abgefangen. Ähnliche Ideen werden bei thermischen Sensoren in speziellen Einhausungen verwandt, um thermale Streustrahlung von dem Sensor abzuhalten. Bei der hier dargestellten Kabelanschlussvorrichtung 10 werden die optischen Baffles 30 als EMC-Baffles verwendet, um eine elektronische Ausrüstung zu schützen. Dies findet insbesondere dort Verwendung, wo optische Verbindungen und optische Verbinder an den Kabeln 14 verwendet werden, wobei ein beträchtlicher Teil des optischen Verbinders nicht-leitend ausgeführt ist und daher transparent zu elektromagnetischer Strahlung ausgeführt ist.

Durch die beispielsweise als Kabelzugentlastung 40 ausgeführte Kabelanschlussvorrichtung 10 wird eine Leitungsdurchführung 12 insbesondere für optische Kabel 14 geschaffen, die auch für die Durchführung von optischen Leitungen voll elektromagnetisch abgeschirmt ist.

### Bezugszeichenliste:

- 10: Kabelanschlussvorrichtung
- 12: Leitungsdurchführung
- 14: Kabel
- 18: Kabeldurchführungsöffnung
- 20: Metallgehäuse
- 22: Gehäuse aus Metall
- 24: weitere Öffnung (Eingangsöffnung)
- 26: innere Oberfläche
- 28: Abschirmstrukturen
- 30: optische Baffle
- 32: Rippen
- 33: Gummiring
- 34: Block
- 36: Kabelführungsnut
- 40: Kabelzugentlastung
- 42: Oberflächenschicht
- 44: erste Hälfte
- 46: zweite Hälfte
- 50: erster Endbereich
- 52: Ringnut
- 54: Rand
- 56: elektrische Verbindung
- 58: zweiter Endbereich
- 60: Krümmung
- 62: Lochdurchmesser
- 66: Kabellängsrichtung
- 68: Umhüllung
- 70: Abschirmschicht
- 72: äußere Isolierung
- 74: elektrische Verbindung

## Patentansprüche

1. Kabelanschlussvorrichtung (10) zum Anschließen eines Kabels (14) an ein elektromagnetisch abzuschirmendes Gehäuse (20) mit einer Umhüllung (68), die zum Umgeben des Kabels (14) im Bereich einer Kabeldurchführungsöffnung (18) des Gehäuses (20) dient und zumindest an ihrer Oberfläche (26) elektrisch leitfähig ausgebildet ist, wobei die Umhüllung (68) eine dem Gehäuse (20) zugeordnete Kabeldurchführungsöffnung (18) in einer Richtung axial zur Kabeldurchführungsöffnung (18) gesehen vollständig überdeckt,
wobei die Umhüllung (68) auf einer zu dem aufzunehmenden Kabel (14) gerichteten inneren Oberfläche (26) mit Abschirmstrukturen (28) zur Dämpfung elektromagnetischer Strahlung versehen ist,
**dadurch gekennzeichnet**,
1.1 dass die Abschirmstrukturen (28) mehrere quer zum Kabelverlauf (66) angeordnete in Richtung auf ein aufzunehmendes Kabel (14) hin vorstehende Rippen (32) aufweisen oder
1.2 dass die Abschirmstrukturen (28) optische und/oder elektromagnetische Baffles (30) aufweisen, die in Richtung Kabelverlauf (66) gesehen in regelmäßigen oder in unregelmäßigen Abständen (64) aufeinander folgen.

2. Kabelanschlussvorrichtung (10) nach Anspruch 1,
**dadurch gekennzeichnet,**
**dass** die Umhüllung (68) als Kabelzugentlastung (40) ausgeführt ist.

3. Kabelanschlussvorrichtung (10) nach einem der voranstehenden Ansprüche,
**dadurch gekennzeichnet,**
**dass** die Umhüllung (68) zum Führen des Kabels (14) auf einer abgewinkelten und/oder gekrümmten Bahn von einer Eingangsöffnung (24) zu der Kabeldurchführungsöffnung (18) ausgebildet ist.

4. Kabelanschlussvorrichtung (10) nach Anspruch 3,
**dadurch gekennzeichnet,**
**dass** die Umhüllung (68) zum Umlenken des Kabels (14) um etwa ca. 45 bis 135° ausgebildet ist.

5. Kabelanschlussvorrichtung (10) nach einem der voranstehenden Ansprüche,
**dadurch gekennzeichnet,**
**dass** die Umhüllung (68) aus leitfähigem Gummimaterial oder einem leitfähigen Polymer oder aus elektrisch leitfähig beschichtetem elastischem Material gebildet ist.

6. Kabelanschlussvorrichtung (10) nach einem der voranstehenden Ansprüche,
**dadurch gekennzeichnet,dass** Rippen (32) in Richtung Kabelverlauf (66) gesehen in regelmäßigen oder in unregelmäßigen Abständen (64) aufeinander folgen.

7. Kabelanschlussvorrichtung (10) nach einem der voranstehenden Ansprüche,
**dadurch gekennzeichnet,**
**dass** die unregelmäßigen Abstände (64) an einem zum Eintreten eines aufzunehmenden Kabels ausgebildeten Eingang der Kabelanschlussvorrichtung (10) größer und im Bereich einer Krümmung (60) kleiner ausgebildet sind.

8. Kabelanschlussvorrichtung (10) nach einem der voranstehenden Ansprüche,
**dadurch gekennzeichnet,**
**dass** sie zum Anschließen eines optischen oder elektrischen Kabels (14) ausgebildet ist.

9. Leitungsdurchführung (12) zum Durchführen einer optischen oder elektrischen Leitung durch eine Durchführungsöffnung (18) in einem elektromagnetisch abzuschirmenden Gehäuse (20), mit einem optischen oder elektrischen Kabel (14), welches durch die als Kabeldurchführungsöffnung (18) ausgebildete Durchführungsöffnung hindurchzuführen ist und einer Kabelanschlussvorrichtung (10) nach einem der voranstehenden Ansprüche.

10. Leitungsdurchführung (12) nach Anspruch 9,
**dadurch gekennzeichnet,**
**dass** die Abschirmstrukturen (28) das Kabel (14) kontaktieren.

11. Verwendung einer Kabelanschlussvorrichtung (10) nach einem der Ansprüche 1 bis 8 zum Anschließen oder Durchführen eines elektrischen oder optischen Kabels (14) oder einer elektrischen oder optischen Leitung durch eine Durchführungsöffnung (18) in einem elektromagnetisch abzuschirmenden Gehäuse (20).

## Claims

1. Cable connection device (10) for connecting a cable (14) to a housing (20) to be electromagnetically shielded, comprising a sheath (68) serving to surround the cable (14) in the region of a cable feedthrough opening (18) of the housing (20) and being constructed to be electrically conductive at least on the surface (26) thereof, wherein the sheath (68) completely covers a cable feedthrough opening (18) assigned to the housing (20) in a direction as viewed axially to the cable feedthrough opening (18), wherein the sheath (68) is provided with shielding structures (28) for absorbing electromagnetic radiation on an inner surface (26) directed to the cable (14) to be received,
**characterized in that**
1.1 the shielding structures (28) present several ribs (32) arranged transversely to the cable routing and protruding towards a cable (14) to be received or
1.2 that the shielding structures (28) present optical and/or electromagnetic baffles (30) succeeding one another at regular or irregular intervals (64) as viewed in the direction of the cable routing (66).

2. Cable connection device (10) according to claim 1, **characterized in that** the sheath (68) is designed as a cable strain relief (40).

3. Cable connection device (10) according to any one of the preceding claims, **characterized in that** the sheath (68) for guiding the cable (14) is formed on an angled and/or curved path from the inlet opening (24) to the cable feedthrough opening (18).

4. Cable connection device (10) according to claim 3, **characterized in that** the sheath (68) is designed for deflecting the cable (14) by about 45 to 135°.

5. Cable connection device (10) according to any one of the preceding claims, **characterized in that** the sheath (68) is formed from a conductive rubber material or a conductive polymer or an electrically conductively coated elastic material.

6. Cable connection device (10) according to any one of the preceding claims, **characterized in that** the ribs (32) succeed one another at regular or irregular intervals (64) as viewed in the direction of the cable routing (66).

7. Cable connection device (10) according to any one of the preceding claims, **characterized in that** the irregular intervals (64) are designed to be larger on an inlet of the cable connection device (10) configured for the entry of a cable to be received and to be smaller in the region of a bend (60).

8. Cable connection device (10) according to any one of the preceding claims, **characterized in that** the same is constructed for connecting an optical or electric cable (14).

9. Cable feedthrough (12) for feeding an optical or electric line through a feedthrough opening (18) in a housing (20) to be electromagnetically shielded, comprising an optical or electric cable (14) to be fed through the feedthrough opening designed as the cable feedthrough opening (18), and a cable connection device (10) according to any one of the preceding claims.

10. Cable feedthrough (12) according to claim 9, **characterized in that** the shielding structures (28) contact the cable (14).

11. Use of a cable connection device (10) according to any one of the claims 1 to 8, for connecting or feeding through an electric or optical cable (14) or an electric or optical line through a feedthrough opening (18) in a housing (20) to be electromagnetically shielded.

## Revendications

1. Dispositif de connexion de câble (10) pour connecter un câble (14) à un boîtier (20) à blinder sur le plan électromagnétique, comportant une enveloppe (68) qui sert à entourer le câble (14) dans la zone d'une ouverture de passage de câble (18) du boîtier (20) et qui est réalisée de façon électriquement conductrice au moins sur sa surface (26), l'enveloppe (68) recouvrant complètement une ouverture de passage de câble (18) associée au boîtier (20) dans une direction vue axialement vers l'ouverture de passage de câble (18),
dans lequel, sur une surface intérieure (26) dirigée vers le câble (14) à loger, l'enveloppe (68) est pourvue de structures de blindage (28) pour atténuer un rayonnement électromagnétique,
**caractérisé en ce que**
1.1 les structures de blindage (28) comprennent plusieurs nervures (32) agencées transversalement au tracé du câble (66) et saillant en direction d'un câble (14) à loger, ou
1.2 les structures de blindage (28) comprennent des baffles optiques et/ou électromagnétiques (30) qui se suivent mutuellement à des distances régulières ou irrégulières (64), vues en direction du tracé de câble (66).

2. Dispositif de connexion de câble (10) selon la revendication 1,
**caractérisé en ce que**
l'enveloppe (68) est réalisée sous la forme d'un moyen de décharge anti-traction de câble (40).

3. Dispositif de connexion de câble (10) selon l'une des revendications précédentes,
**caractérisé en ce que**
l'enveloppe (68) est réalisée pour guider le câble (14) sur une voie coudée et/ou recourbée depuis une ouverture d'entrée (24) jusqu'à l'ouverture de passage de câble (18).

4. Dispositif de connexion de câble (10) selon la revendication 3,
**caractérisé en ce que**
l'enveloppe (68) est réalisée pour renvoyer le câble (14) d'environ 45 à 135°.

5. Dispositif de connexion de câble (10) selon l'une des revendications précédentes,
**caractérisé en ce que**
l'enveloppe (68) est réalisée en un matériau de caoutchouc conducteur ou en un polymère conducteur ou en un matériau élastique doté d'un revêtement électriquement conducteur.

6. Dispositif de connexion de câble (10) selon l'une des revendications précédentes,
**caractérisé en ce que**
des nervures (32) se suivent mutuellement à des distances régulières ou irrégulières (64), vues en direction du tracé de câble (66).

7. Dispositif de connexion de câble (10) selon l'une des revendications précédentes,
**caractérisé en ce que**
les distances irrégulières (64) sont réalisées plus grandes à une entrée du dispositif de connexion de câble (10) prévue pour introduire un câble à loger, et elles sont réalisées plus petites dans une zone d'une courbure (60).

8. Dispositif de connexion de câble (10) selon l'une des revendications précédentes,
**caractérisé en ce que**
il est réalisé pour connecter un câble optique ou électrique (14).

9. Passage de ligne (12) pour faire passer une ligne optique ou électrique à travers une ouverture de passage (18) dans un boîtier (20) à blinder sur le plan électromagnétique, comportant un câble optique ou électrique (14) à faire passer à travers l'ouverture de passage réalisée à titre d'ouverture de passage de câble (18), et un dispositif de connexion de câble (10) selon l'une des revendications précédentes.

10. Passage de ligne (12) selon la revendication 9,
**caractérisé en ce que**
les structures de blindage (28) sont en contact avec le câble (14).

11. Utilisation d'un dispositif de connexion de câble (10) selon l'une des revendications 1 à 8 pour connecter ou faire passer un câble électrique ou optique (14) ou une ligne électrique ou optique à travers une ouverture de passage (18) dans un boîtier (20) à blinder sur le plan électromagnétique.
